# EUROPEAN PATENT APPLICATION

(11) **EP 4 741 848 A1**
(43) Date of publication of application: **13.05.2026**
(21) Application number: 24907637.3
(22) Date of filing: 27.06.2024
(51) Int. Cl.: G01R 31/374, G01R 31/382, G01R 31/392, G01R 31/396, G01R 31/371, G01R 31/367, G01R 19/10, G01R 19/165, H01M 10/48

(54) **BATTERY SYSTEM AND BATTERY PACK DIAGNOSIS METHOD BY SUPPLEMENTING CELL VOLTAGE AND CELL TEMPERATURE DATA**

(30) Priority: 21.12.2023 KR 20230188920; 19.04.2024 KR 20240052995
(71) Applicant: LG Energy Solution, Ltd., Seoul 07335 (KR)
(72) Inventor: KI, Jeong Seok, Daejeon 34122 (KR); JUNG, Yoonchul, Daejeon 34122 (KR); PARK, Won Seok, Daejeon 34122 (KR)
(74) Representative: Plasseraud IP
(86) International application number: PCT/KR2024/008971
(87) International publication number: WO 2025/135347

(57) **Abstract**

The present disclosure relates to a battery system and a battery pack diagnosis method by supplementing a cell voltage and cell temperature data. The battery system may include a battery pack that includes a plurality of battery cells, a cell monitoring controller (CMC) that is configured to monitor a plurality of first cell voltages and a plurality of first cell temperatures of the plurality of battery cells, and a battery management system (BMS) that is configured to determine a wireless communication status with the CMC, diagnose the battery pack based on the plurality of first cell voltages and the plurality of first cell temperatures received from the CMC according to the wireless communication status with the CMC, and diagnose the battery pack by estimating a plurality of second cell voltages and a plurality of second cell temperatures of the plurality of battery cells.

## Description

### [Technical Field]

### CROSS-REFERENCE TO RELATED APPLICATION

This application claims priority to and the benefit of Korean Patent Application No. 10-2023-0188920 filed in the Korean Intellectual Property Office on December 21, 2023, and Korean Patent Application No. 10-2024-0052995 filed in the Korean Intellectual Property Office on April 19, 2024, the entire contents of which are incorporated herein by reference.

The present disclosure relates to a battery system and a battery pack diagnosis method by supplementing a cell voltage and cell temperature data.

### [Background Art]

A battery management system (BMS) may receive cell voltage and cell temperature values from a cell monitoring controller (CMC) that monitors the cell voltages and cell temperatures of each of a plurality of battery cells. The BMS and the CMC may communicate wirelessly. However, when the wireless connection with the CMC is poor, the BMS may not know the exact cell voltage and cell temperature, and thus may stop the supply of power to a battery pack.

However, when the supply of power to the battery pack stops whenever the communication with the CMC is unstable, the utilization of the battery is unstable, so there is a need to supplement the cell voltage and cell temperature data due to the communication failure with the CMC in order to stably supply power.

### [Disclosure]

### [Technical Problem]

The present disclosure attempts to provide a battery system capable of supplementing a cell voltage and cell temperature data when a wireless connection between a CMC and a BMS is unstable, and a battery pack diagnosis method by supplementing a cell voltage and cell temperature data.

### [Technical Solution]

According to an aspect of the present disclosure, a battery system may include a battery pack that includes a plurality of battery cells, a cell monitoring controller (CMC) that is configured to monitor a plurality of first cell voltages and a plurality of first cell temperatures of the plurality of battery cells, and a battery management system (BMS) that is configured to determine a wireless communication status with the CMC, diagnose the battery pack based on the plurality of first cell voltages and the plurality of first cell temperatures received from the CMC according to the wireless communication status with the CMC, and diagnose the battery pack by estimating a plurality of second cell voltages and a plurality of second cell temperatures of the plurality of battery cells.

The BMS may include a main control unit (MCU) that derives cell voltage deviations of each of the plurality of battery cells based on a pack voltage of the battery pack and stores the derived cell voltage deviations in a memory, when the wireless communication status with the CMC is in a normal state, and a diagnostic unit that diagnoses the battery pack based on the plurality of first cell voltages and the plurality of first cell temperatures received from the CMC, when the wireless communication status with the CMC is in the normal state.

The BMS may further include at least one input terminal that is electrically connected to at least one of two terminals of the battery pack, and the MCU may determine, as the cell voltage deviations of each of the plurality of battery cells, a value obtained by subtracting each of the plurality of first cell voltages from a value obtained by dividing the pack voltage of the battery pack derived based on a pack voltage signal received from at least one of the two terminals of the battery pack by a number of the plurality of battery cells.

The BMS may further include a cell voltage estimation unit that determines, as the plurality of second cell voltages, a value obtained by subtracting a cell voltage deviation stored in a normal state before an abnormal state of the wireless communication with the CMC from a value obtained by dividing a pack voltage of the battery pack derived from a pack voltage signal received from at least one of the two terminals of the battery pack by a number of the plurality of battery cells, when the wireless communication with the CMC is in the abnormal state.

The battery system may further include a cooling unit that includes an inlet into which a coolant is injected and an outlet through which the coolant is discharged to cool the battery pack by heat exchange with the battery pack through the coolant, a first temperature sensor that measures a temperature of the inlet of the cooling unit, a second temperature sensor that measures a temperature of the outlet of the cooling unit, and a current sensor that measures a pack current of the battery pack, in which the BMS may further include a first input terminal that is electrically connected to the first temperature sensor, a second input terminal that is electrically connected to the second temperature sensor, a third input terminal that is electrically connected to the current sensor, and a communication unit that receives the plurality of first cell voltages and the plurality of first cell temperatures received from the CMC via wireless communication.

A memory may pre-store a lookup table that indicates cell temperature values according to ranges of the pack current and coolant temperature, respectively, through a pack test for the battery pack, the BMS may further include a cell temperature estimation unit that calculates the temperature of the coolant from the temperature of the inlet and the temperature of the outlet and derives a temperature of a plurality of second cells based on the temperature of the coolant, the pack current, and the lookup table, when the wireless communication with the CMC is in an abnormal state, and the diagnostic unit may diagnose the battery pack based on the plurality of second cell voltages and the plurality of second cell temperatures when the wireless communication with the CMC is in the abnormal state.

According to another aspect of the present disclosure, a battery pack diagnosis method by a battery system that includes a battery pack including a plurality of battery cells, a cell monitoring controller (CMC) configured to monitor a plurality of first cell voltages and a plurality of first cell temperatures of the plurality of battery cells, and a battery management system (BMS) configured to diagnose the battery pack, the method may include determining a wireless communication status with the CMC, and diagnosing the battery pack based on the plurality of first cell voltages and the plurality of first cell temperatures received from the CMC according to the wireless communication status with the CMC and diagnosing the battery pack by estimating a plurality of second cell voltages and a plurality of second cell temperatures of the plurality of battery cells.

The method may further include deriving cell voltage deviations of each of the plurality of battery cells based on a pack voltage of the battery pack and storing the derived cell voltage deviations in a memory, when the wireless communication with the CMC is in a normal state, and diagnosing the battery pack based on the plurality of first cell voltages and the plurality of first cell temperatures received from the CMC, when the wireless communication with the CMC is in the normal state.

The method may further include determining, as the cell voltage deviations of each of the plurality of battery cells, a value obtained by subtracting each of the plurality of first cell voltages from a value obtained by dividing the pack voltage of the battery pack derived based on a pack voltage signal received from at least one of two terminals of the battery pack by a number of the plurality of battery cells, in which the BMS may further include at least one input terminal that is electrically connected to at least one of the two terminals of the battery pack.

The method may further include when the wireless communication with the CMC is in an abnormal state, deriving a pack voltage of the battery pack based on a pack voltage signal received from at least one of two terminals of the battery pack, and determining, as the plurality of second cell voltages, a value obtained by subtracting a cell voltage deviation stored in a normal state before the abnormal state of the wireless communication with the CMC from a value obtained by dividing the pack voltage of the battery pack by a number of the plurality of battery cells.

The method may further include receiving a signal indicating a temperature of an inlet by a first input terminal electrically connected to a first temperature sensor measuring the temperature of the inlet of a cooling unit that includes the inlet into which a coolant is injected and an outlet through which the coolant is discharged to cool the battery pack by heat exchange with the battery pack through the coolant, receiving a signal indicating a temperature of the outlet by a second input terminal electrically connected to a second temperature sensor measuring the temperature of the outlet of the cooling unit, receiving a signal indicating a pack current by a third input terminal electrically connected to a current sensor measuring the pack current of the battery pack, and receiving the plurality of first cell voltages and the plurality of first cell temperatures received from the CMC via wireless communication.

The method may further include when the wireless communication with the CMC is in an abnormal state, calculating a temperature of the coolant from the temperature of the inlet and the temperature of the outlet, deriving the plurality of second cell temperatures based on the temperature of the coolant, the pack current, and a lookup table, and diagnosing the battery pack based on the plurality of second cell voltages and the plurality of second cell temperatures when the wireless communication with the CMC is in the abnormal state, in which a memory may pre-store the lookup table that indicates cell temperature values according to ranges of the pack current and the coolant temperature, respectively, through a pack test for the battery pack.

### [Advantageous Effects]

According to the present disclosure, a BMS receives cell temperature and cell voltage information of a battery from a CMC, but even when the wireless connection with the CMC is unstable, by continuously monitoring the cell voltage and cell temperature, it is possible to stably supply battery power to vehicles, etc., without immediately interrupting the supply of power to a battery pack.

According to the present disclosure, by continuously monitoring the cell voltage and cell temperature, it is possible to implement a more robust battery system design in terms of safety.

Since a coolant that cools a battery pack including a plurality of battery cells cools the temperature of the battery through heat exchange with the battery, it may be seen that there is a relationship between the temperature of the coolant and the cell temperature of the battery cell. According to the present disclosure, by utilizing a lookup table that indicates the relationship between the temperature of the coolant and the cell temperature of the battery cell, it is possible to improve the accuracy of cell temperature estimation.

### [Description of the Drawings]

FIG. 1 is a block diagram schematically illustrating a battery system according to an embodiment.
FIG. 2 is a block diagram schematically illustrating a configuration of a battery pack illustrated in FIG. 1.
FIG. 3 is a flowchart of a battery pack diagnosis method according to an embodiment.
FIG. 4 is a table illustrating an example for describing an operation of a BMS estimating cell voltage of each of a plurality of battery cells according to an embodiment.

### [Mode for Invention]

Hereafter, embodiments of the present disclosure will be described in detail with reference to the accompanying drawings and the same or similar components are given the same reference numerals and are not repeatedly described. The suffix "module" and/or "unit" for components used in the following description is given or mixed in consideration of only the ease of writing of the specification, and therefore, do not have meanings or roles that distinguish from each other in themselves. In addition, when it is determined that a detailed description for known technologies related to the present specification in describing embodiments disclosed in the present specification may unnecessarily obscure the gist of embodiments disclosed in the present specification, the detailed description will be omitted. Further, it should be understood that the accompanying drawings are provided only in order to allow embodiments of the present disclosure to be easily understood, and the spirit of the present disclosure is not limited by the accompanying drawings, but includes all the modifications, equivalents, and substitutions included in the spirit and the scope of the present disclosure.

Terms including an ordinal number such as first, second, etc., may be used to describe various components, but the components are not limited to these terms. The above terms are used solely for the purpose of distinguishing one component from another.

It will be further understood that terms "include" or "have" used in the present specification specify the presence of features, numerals, steps, operations, components, parts mentioned in the present specification, or combinations thereof, but do not preclude the presence or addition of one or more other features, numerals, steps, operations, components, parts, or combinations thereof.

Among the components according to an embodiment, a program implemented as a set of instructions specifying a control algorithm necessary for controlling other components may be installed in a component that controls other components under specific control conditions. The control component may process input data and stored data according to installed programs to generate output data. The control component may include a non-volatile memory for storing programs and a memory for storing data.

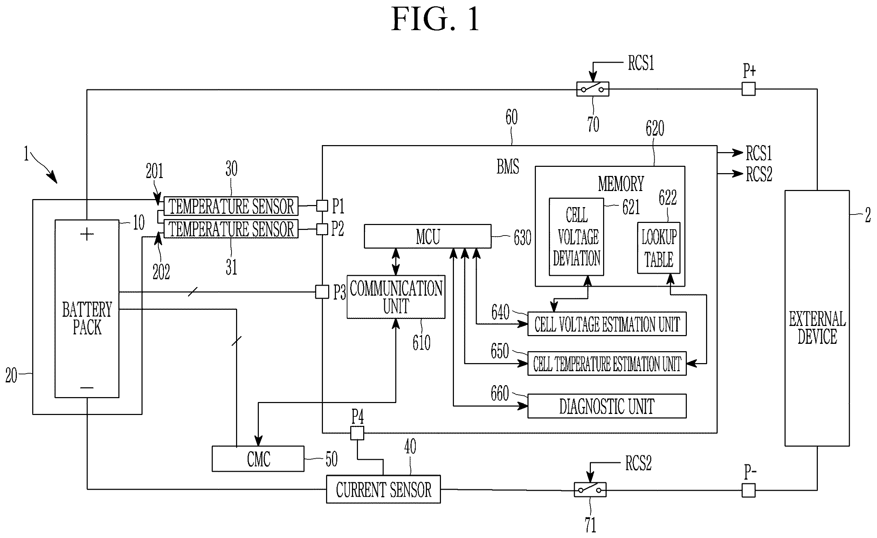

FIG. 1 is a block diagram schematically illustrating a battery system according to an embodiment.

Referring to FIG. 1, a battery system 1 may include a battery pack 10, a cooling unit 20, two temperature sensors 30 and 31, a current sensor 40, a cell monitoring controller (CMC) 50, a battery management system (BMS) 60, and relays 70 and 71.

One end of the relays 70 and 71 is connected to the battery pack 10, and the other end of the relays 70 and 71 is connected to at least one component in an external device 2. Closing and opening of the relays 70 and 71 may be controlled according to relay control signals RCS1 and RCS2 supplied from the BMS 60.

The battery system 1 may be connected to the external device 2. The external device 2 may include a load and a charging device such as an inverter or a converter. When the external device 2 is a charger, both ends P+ and P-of the battery system 1 may connected to the charger and charged by receiving power from the charger. When the external device 2 is a load, both ends P+ and P- of the battery system 1 are connected to the load so that the power supplied by the battery pack 10 may be discharged through the load.

The battery pack 10 may include a plurality of battery cells.

The cooling unit 20 may cool the battery pack 10 by heat exchange with the battery pack 10 through a coolant. The cooling unit 20 may include an inlet 201 and an outlet 202. The inlet 201 may be an area where the coolant is injected into the cooling unit 20. The outlet 202 may be an area where the coolant is discharged from the cooling unit 20. The cooling unit 20 may prevent the performance degradation of the battery pack 10 by cooling the battery pack 10 to a predetermined degree by the heat exchange with the battery pack 10.

The temperature sensor 30 may measure the temperature of the inlet 201. The temperature sensor 30 may generate a signal indicating the temperature of the inlet 201 and transmit the generated signal to the BMS 60. The temperature sensor 31 may measure the temperature of the outlet 202. The temperature sensor 31 may generate a signal indicating the temperature of the outlet 202 and transmit the generated signal to the BMS 60.

The current sensor 40 is connected to one end of the battery pack 10 and may measure the current flowing in one end of the battery pack 10. The current sensor 40 may generate a signal indicating a pack current of the battery pack 10 and transmit the generated current to the BMS 60. The current sensor 40 may be located on a high voltage line connected from the battery pack 10 to both ends P+ and P- of the battery system 1. The current sensor 40 may be implemented as a resistance detection type that detects a current using resistance or a magnetic field detection type that detects a magnetic field.

The CMC 50 may monitor a plurality of cell voltages and a plurality of cell temperatures of a plurality of battery cells (hereinafter, referred to as "plurality of battery cells) included in the battery pack 10. For example, the CMC 50 may derive cell voltages of each of the plurality of battery cells based on a signal indicating voltages across of each of the plurality of battery cells.

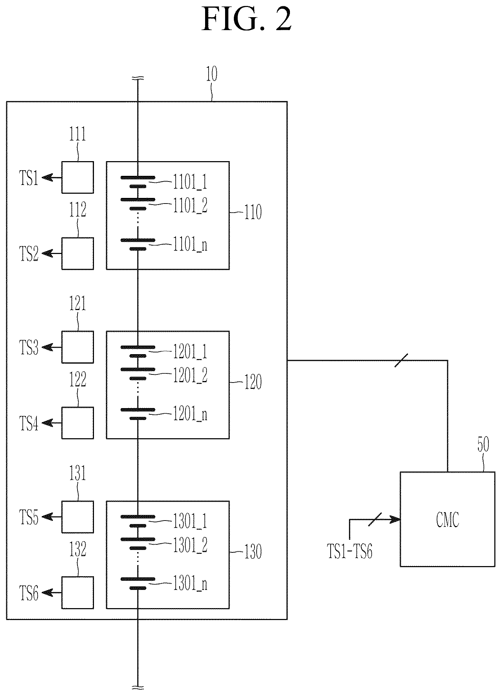

FIG. 2 is a block diagram schematically illustrating a configuration of a battery pack illustrated in FIG. 1.

Referring to FIG. 2, the battery pack 10 may include a plurality of battery modules 110, 120, and 130 and a plurality of temperature sensors 111, 112, 121, 122, 131, and 132.

The plurality of battery modules 110, 120, and 130 may be connected in series. Each of the plurality of battery modules 110, 120, and 130 (e.g., 110) may include corresponding battery cells 1101_1 to 1101_n among the plurality of battery cells 1101_1 to 1101_n, 1201_1 to 1201_n, and 1301_1 to 1301_n. The plurality of battery cells 1101_1 to 1101_n, 1201_1 to 1201_n, and 1301_1 to 1301_n may be connected in series. Here, n is a natural number greater than or equal to 3.

In FIG. 2, the battery pack 10 includes the plurality of battery cells 1101_1 to 1101_n, 1201_1 to 1201_n, and 1301_1 to 1301_n connected in series, and the number of battery modules 110, 120, and 130 is illustrated as three, but this is for convenience of description and the present disclosure is not limited thereto. The battery pack 10 may include two or more battery modules, and each battery module may include two or more battery cells connected in series, a plurality of battery cells in which two or more battery cells connected in parallel are connected in series, or two or more battery cells connected in parallel.

The two temperature sensors 111 and 112 may be located adjacent to the battery module 110, the two temperature sensors 121 and 122 may be located adjacent to the battery module 120, and the two temperature sensors 131 and 132 may be located adjacent to the battery module 130.

In FIG. 2, two (e.g., 111 and 112) of the plurality of temperature sensors 111, 112, 121, 122, 131, and 132 are located adjacent to each (e.g., 110) of the plurality of battery modules 110, 120, and 130, but this is for convenience of description and the present disclosure is not limited thereto. One or more temperature sensors may be located adjacent to each of the plurality of battery modules 110, 120, and 130.

Each (e.g., 111) of the plurality of temperature sensors 111, 112, 121, 122, 131, and 132 may measure a temperature of a point where each temperature sensor (e.g., 111) is located and generate a corresponding temperature measurement signal (e.g., TS1) among a plurality of temperature measurement signals TS1 to TS6. The plurality of temperature sensors 111, 112, 121, 122, 131, and 132 may transmit the plurality of temperature measurement signals TS1 to TS6 to the CMC 50.

Since the points where each temperature sensor is located are located adjacent to the battery module, each temperature sensor may be located adjacent to each of the plurality of battery cells constituting the battery module. That is, the temperature measured by each temperature sensor may be similar to the temperature of each of the plurality of battery cells.

The CMC 50 may receive the plurality of temperature measurement signals TS1 to TS6 from the plurality of temperature sensors 111, 112, 121, 122, 131, and 132 provided in the battery pack 10. The CMC 50 may determine a representative value for at least one of the battery cell (e.g., 1101_1 to 1101_n) corresponding to each (e.g., TS1) of the plurality of temperature sensors TS1 to TS6 among the plurality of battery cells 1101_1 to 1101_n, 1201_1 to 1201_n, and 1301_1 to 1301_n based on the measurement values of the plurality of temperature measurement signals TS1 to TS6 received from the plurality of temperature sensors 111, 112, 121, 122, 131, and 132.

In the example of FIG. 2, the CMC 50 may determine two representative values representing the cell temperatures of each of the plurality of battery cells 1101_1 to 1101_n by using the measurement values of the two temperature measurement signals TS1 and TS2 received from the two temperature sensors 111 and 112 located adjacent to the battery module 110. The CMC 50 may determine two representative values representing the cell temperatures of each of the plurality of battery cells 1201_1 to 1201_n by using the measurement values of the two temperature measurement signals TS3 and TS4 received from the two temperature sensors 121 and 122 located adjacent to the battery module 110. The CMC 50 may determine two representative values representing the cell temperatures of each of the plurality of battery cells 1301_1 to 1301_n by using the measurement values of the two temperature measurement signals TS5 and TS6 received from the two temperature sensors 131 and 132 located adjacent to the battery module 130.

For example, in FIG. 2, when n is 10, the CMC 50 may determine the representative values representing the cell temperatures of each of the battery cells (e.g., 1101 to 1105) corresponding to the temperature sensor 111 among the plurality of battery cells 1101_1 to 1101_10 by using the measurement values of the temperature measurement signal TS1. In addition, the CMC 50 may determine representative values representing the cell temperatures of each of the battery cells (e.g., 1106 to 1110) corresponding to the temperature sensor 112 among the plurality of battery cells 1101_1 to 1101_10 using the measurement value of the temperature measurement signal TS2.

Hereinafter, for convenience of description, each of the representative values of the cell temperatures of each of the plurality of battery cells is referred to as a "cell temperature."

The CMC 50 may transmit the representative values (hereinafter, "plurality of cell temperatures") corresponding to the plurality of temperature sensors 111, 112, 121, 122, 131, and 132 determined using the plurality of temperature measurement signals TS1 to TS6 to the BMS 60.

Referring back to FIG. 1, in FIG. 1, the CMC 50 is illustrated as monitoring the plurality of cell voltages and the plurality of cell temperatures of the plurality of battery cells, but this is for convenience of description and the present disclosure is not limited thereto. In some embodiments, the battery system 1 includes a battery monitoring integrated circuit (BMIC), and the description of the CMC 50 described below may be equally applied to the BMIC.

The CMC 50 may generate signals indicating the plurality of cell voltages and the plurality of cell temperatures of the plurality of battery cells and transmit the generated signals to the BMS 60. In FIG. 1, the number of CMCs 50 is illustrated as one, but this is only for convenience of description, and the present disclosure is not limited thereto. In some embodiments, the battery system 1 may include two or more CMCs.

The BMS 60 may receive the signals indicating the plurality of cell voltages and the plurality of cell temperatures of the plurality of battery cells from the CMC 50 via wireless communication. The BMS 60 may determine the wireless communication status with the CMC 50, diagnose the battery pack 10 based on a plurality of first cell voltages and a plurality of first cell temperatures received from the CMC 50 according to the wireless communication status with the CMC 50, or diagnose the battery pack 10 by estimating a plurality of second cell voltages and a plurality of second cell temperatures of the plurality of battery cells. The BMS 60 may determine a power limit of the battery pack 10 based on the plurality of first cell voltages and a plurality of first cell temperatures, or based on the plurality of second cell voltages and the plurality of second cell temperatures.

The plurality of first cell voltages may represent the plurality of cell voltages received by the BMS 60 from the CMC 50, and the plurality of second cell voltages may represent cell voltage information estimated by the BMS 60 in response to the plurality of first cell voltages. The plurality of first cell temperatures may represent the plurality of cell temperatures received by the BMS 60 from the CMC 50, and the plurality of second cell temperatures may represent the cell voltage information estimated by the BMS 60 in response to the plurality of first cell temperatures.

The power limit of the battery pack 10 may include a discharge power limit of the battery pack 10 and/or a charge power limit of the battery pack 10. The discharge power limit may be an amount of power that may be continuously expected from the battery pack 10 without exceeding the maximum allowable discharge current of the battery pack 10 for a predetermined period of time. A charge power limit value may be an amount of power that may be continuously supplied to the battery pack 10 without exceeding the maximum allowable discharge current of the battery pack 10 for a predetermined period of time.

The BMS 60 may include a plurality of input terminals P1 to P4. The input terminal P1 may be electrically connected to the temperature sensor 30 and may receive a signal indicating a temperature of an inlet 201 from the temperature sensor 30. The input terminal P2 may be electrically connected to the temperature sensor 31 and may receive a signal indicating a temperature of an outlet 202 from the temperature sensor 31. The input terminal P3 may be electrically connected to at least one of the two terminals of the battery pack 10 and may receive a signal indicating the voltage of at least one of the two terminals of the battery pack 10. The input terminal P3 may be implemented as at least one input terminal that receives each signal indicating the voltage of at least one of the two terminals of the battery pack 10. The MCU 630 may derive a pack voltage of the battery pack 10 based on a signal indicating the voltage of at least one of the two terminals of the battery pack 10. The input terminal P4 may be electrically connected to the current sensor 40 and receive a signal indicating the pack current of the battery pack 10.

The BMS 60 may include a communication unit 610, a memory 620, the main control unit (MCU) 630, a cell voltage estimation unit 640, a cell temperature estimation unit 650, and a diagnostic unit 660.

The communication unit 610 may wirelessly communicate with the CMC 50 and receive the signals indicating the plurality of cell voltages and the plurality of cell temperatures of the plurality of battery cells from the CMC 50. The communication unit 610 may transmit the signals indicating the plurality of cell voltages and the plurality of cell temperatures of the plurality of battery cells received from the CMC 50 to the MCU 630.

The MCU 630 may determine whether the wireless communication with the CMC 50 is in a normal state. For example, when there is an error in the data received by the communication unit 610, when there is an error in the communication status check bit included in the data received by the communication unit 610, or when the IP, time, etc., of each frame received by the communication unit 610 are not updated, the MCU 630 may determine that the wireless communication with the CMC 50 is in an abnormal state rather than a normal state.

When it is determined that the wireless communication with the CMC 50 is in the normal state, the MCU 630 may derive cell voltage deviations 621 of each of the plurality of battery cells based on the signal received by the communication unit 610 from the CMC 50 and the pack voltage of the battery pack 10 and store the derived cell voltage deviations 621 in the memory 620, and transmit signals indicating the plurality of cell voltages and the plurality of cell temperatures of the plurality of battery cells indicated by the signal received from the CMC 50 to the diagnostic unit 660.

The MCU 630 may determine, as the cell voltage deviations 621 of each of the plurality of battery cells, a value obtained by subtracting each of the plurality of cell voltages of the plurality of battery cells received from the CMC 50 from a value obtained by dividing the pack voltage of the battery pack 10 derived by the MCU 630 by the number of the plurality battery cells based on the signal received from the input terminal P3. Hereinafter, the number of battery cells may be pre-stored in the memory 620.

When it is determined that the wireless communication with the CMC 50 is in a normal state, the diagnostic unit 660 may diagnose the battery pack 10 based on the plurality of cell voltages and plurality of cell temperatures of the plurality of battery cells received from the CMC 50. For example, when at least one of the plurality of cell voltages is outside a normal operating range of the battery cell, and/or at least one of the plurality of cell temperatures exceeds a normal temperature threshold of the battery cell, the diagnostic unit 660 may diagnose the battery pack 10 as the abnormal state.

For example, when it is determined that the plurality of cell voltages and plurality of cell temperatures of the plurality of battery cells are in the normal operating range of the battery pack 10, the diagnostic unit 660 may maintain the power of the battery pack 10 as before. When it is determined that the plurality of cell voltages and plurality of cell temperatures of the plurality of battery cells are outside the normal operating range of the battery pack 10, the diagnostic unit 660 may calculate the power limit value of the battery pack 10 according to the plurality of cell voltages and plurality of cell temperatures of the plurality of battery cells.

The diagnostic unit 660 may transmit cell information for the plurality of battery cells to an electronic control unit (ECU) of the vehicle. The diagnostic unit 660 may transmit the cell information to the ECU of the vehicle, for example, via the CAN communication. The cell information may be the plurality of cell voltages and the plurality of cell temperatures of the plurality of battery cells based on the signal received from the CMC 50, or may be the estimated cell voltages and estimated cell temperatures of each of the plurality of battery cells received from the cell voltage estimation unit 640 and the cell temperature estimation unit 650.

When it is determined that the wireless communication with the CMC 50 is in the normal state, the MCU 630 may derive the cell voltage deviation 621 and store the derived cell voltage deviation 621 in the memory 620. For example, the MCU 630 may derive the cell voltage deviation 621 at a predetermined cycle and store the derived cell voltage deviation 621 in the memory 620. Here, the predetermined cycle may be a cycle according to the cycle in which the communication unit 610 receives the signals indicating the plurality of cell voltages and the plurality of cell temperatures of the plurality of battery cells from the CMC 50. The cell voltage deviation 621 stored in the memory 620 may be updated with the latest cell voltage deviation among the plurality of cell voltage deviations derived from the MCU 630. The cell voltage deviation 621 derived from the MCU 630 may be stored in the memory 620.

A lookup table 622 may be pre-stored in the memory 620. The lookup table 622 may represent the cell temperature values according to the ranges of the pack current and the coolant temperature of the cooling unit 20, respectively, through a pack test for the battery pack 10. Here, the coolant temperature may be the difference between the temperature of the inlet 201 and the temperature of the outlet 202. Here, the cell temperature values may be temperature values corresponding to the plurality of temperature sensors 111, 112, 121, 122, 131, and 132 illustrated in FIG. 2. The MCU 630 may calculate the coolant temperature based on the temperature of the inlet 201 received through the input terminal P1 and the temperature of the outlet 202 received through the input terminal P2.

The lookup table may be generated through the pack test for the battery pack 10. Here, the pack test may be a test that measures the cell temperatures of each of the plurality of battery cells according to each coolant temperature by flowing a predetermined pack current to the battery pack 10. For example, according to a first pack test, a first lookup table between the pack current and the cell temperature may be generated, and according to a second pack test, a second lookup table between the pack current and the coolant temperature (e.g., the difference between the temperature of the inlet 201 and the temperature of the outlet 202) may be generated, and based on the first lookup table and the second lookup table, a final lookup table indicating cell temperature data according to ranges of the pack current and the coolant temperature, respectively, may be generated. In an embodiment, the lookup table 622 may be the final lookup table here.

For example, each row of the lookup table may correspond to a current range that divides the pack current into a predetermined number of sections, and each column of the lookup table may correspond to a temperature range that divides the temperature of the coolant, which represents the difference between the temperature of the inlet 201 and the temperature of the outlet 202, into a predetermined number of sections. Data included in the lookup table may include cell temperature values corresponding to each row and each column.

When it is determined that the wireless communication with the CMC 50 is in an abnormal state, the MCU 630 may transmit the pack voltage of the battery pack 10 derived from the signal received through the input terminal P3 to the cell voltage estimation unit 640. The cell voltage estimation unit 640 may determine, as the estimated cell voltages of each of the plurality of battery cells, a value obtained by subtracting the cell voltage deviations 621 of each of the plurality of battery cells from a value obtained by dividing the pack voltage of the battery pack 10 by the number of battery cells. Here, the cell voltage deviations 621 of each of the plurality of battery cells may be the cell voltage deviations stored in the memory 620 in the normal state before the abnormal state of the wireless communication with the CMC 50. The cell voltage estimation unit 640 may transmit the estimated cell voltages of each of the plurality of battery cells to the diagnostic unit 660.

When it is determined that the wireless communication with the CMC 50 is in the abnormal state, the MCU 630 may calculate the coolant temperature of the cooling unit 20 based on the temperature of the inlet 201 and the temperature of the outlet 202 derived according to the signals received through the input terminals P1 and P2, derive the pack current of the battery pack 10 based on the pack current of the battery pack 10 received through the input terminal P4, and transmit the coolant temperature and the pack current to the cell temperature estimation unit 650. The cell temperature estimation unit 650 may extract, from the lookup table 622, a target cell temperature value corresponding to the coolant temperature and the pack current received from the MCU 630. The cell temperature estimation unit 650 may determine the extracted target cell temperature value as the estimated cell temperature and transmit the determined extracted target cell temperature to the diagnostic unit 660.

When it is determined that the wireless communication with the CMC 50 is in the abnormal state, the diagnostic unit 660 may diagnose the battery pack 10 based on the estimated cell voltage received from the cell voltage estimation unit 640 and the estimated cell temperature received from the cell temperature estimation unit 650.

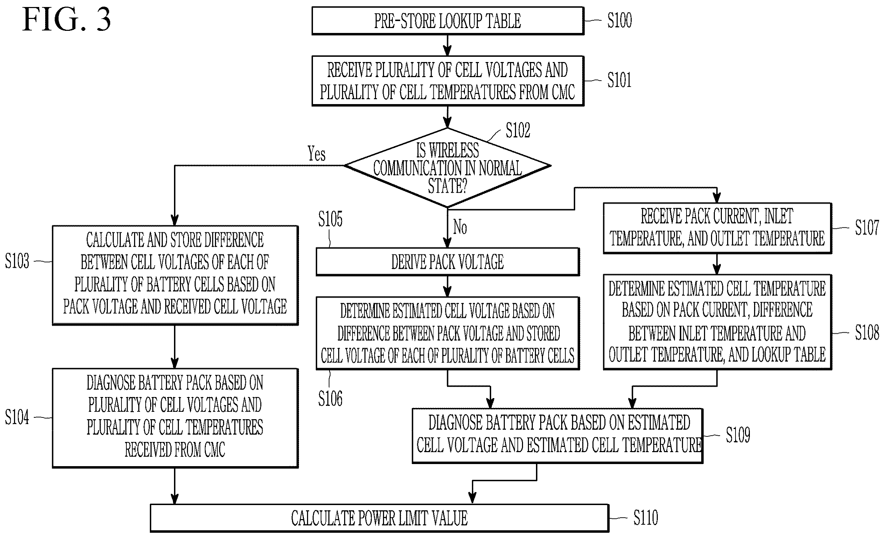

FIG. 3 is a flowchart of a method of diagnosing a battery pack according to an embodiment.

Hereinafter, descriptions of each component of the battery system 1 that overlap with the above description may be omitted.

Referring to FIG. 3, the lookup table 622 may be pre-stored in the memory 620 (S100).

The BMS 60 may receive the plurality of cell voltages and the plurality of cell temperatures of the plurality of battery cells from the CMC 50 (S101).

The BMS 60 may determine whether the wireless communication with the CMC 50 is in the normal state (S102).

When the wireless communication with the CMC 50 is in the normal state in step S102, the BMS 60 may calculate the cell voltage deviations of each of the plurality of battery cells by subtracting each of the plurality of cell voltages of the plurality of battery cells received from the CMC 50 from the value obtained by dividing the pack voltage of the battery pack 10 derived from the voltage measurement signal received from both ends of the battery pack 10 through the input terminal P3 by the number of battery cells and store the calculated cell voltage deviations in the memory 620 (S103).

Following step S103, the BMS 60 may diagnose the battery pack 10 based on the plurality of cell voltages and the plurality of cell temperatures of the plurality of battery cells received from the CMC 50 (S104).

When the wireless communication with the CMC 50 is in the abnormal state in step S102, the BMS 60 may derive the pack voltage of the battery pack 10 from the voltage measurement signals received from both ends of the battery pack 10 through the input terminal P3 (S105).

Following step S105, the BMS 60 may determine the plurality of estimated cell voltages of the plurality of battery cells based on the derived pack voltage and the cell voltage deviations 621 of each of the plurality of battery cells stored in the memory 620 (S106). Here, the cell voltage deviation 621 stored in the memory 620 may be a value stored in the normal state before the abnormal state of the wireless communication with the CMC 50. The BMS 60 may determine, as the estimated cell voltages of each of the plurality of battery packs, the value obtained by subtracting the cell voltage deviations 621 of each of the plurality of battery cells stored in the memory 620 from the value obtained by dividing the pack voltage derived in step S105 by the number of battery cells.

In addition, when the wireless communication with the CMC 50 is in the abnormal state in step S102, the BMS 60 may receive signals indicating the pack current of the battery pack 10 from the current sensor 40, the temperature of the inlet 201 from the temperature sensor 30, and the temperature of the outlet 202 from the temperature sensor 31, respectively (S107).

Following step S107, the BMS 60 may determine the plurality of estimated cell temperatures of the plurality of battery cells based on the pack current, the difference between the temperature of the inlet and the temperature of the outlet, and the lookup table (S108).

Following steps S106 and S108, the BMS 60 may diagnose the battery pack 10 based on the plurality of estimated cell voltages and the plurality of estimated cell temperatures of the estimated the plurality of battery cells (S109).

Following step S109, the BMS 60 may calculate the power limit value of the battery pack 10 based on the cell voltage and the cell temperature derived from the signal received from the CMC 50 in step S104 or based on the cell voltage and the cell temperature estimated in step S109 (S110).

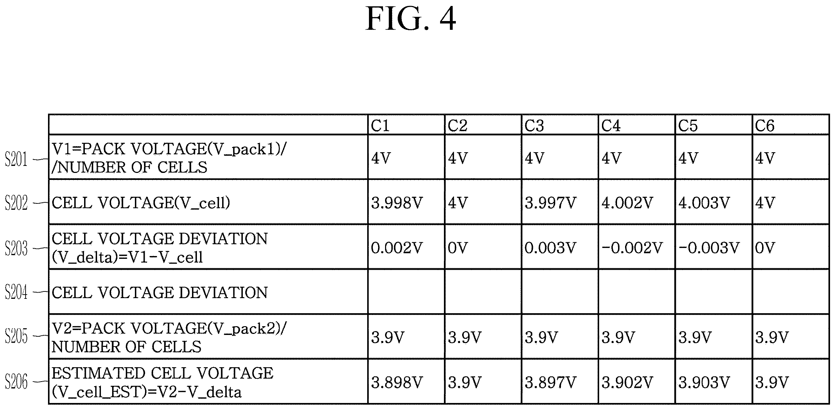

FIG. 4 is a table illustrating an example for describing an operation of the BMS estimating the cell voltages of each of a plurality of battery cells according to an embodiment.

Referring to FIG. 4, steps S201 to S203 may describe the operation of the BMS 60 when the BMS 60 determines that the wireless communication with the CMC 50 is in the normal state.

Hereinafter, referring to FIG. 4, it will be described that the plurality of battery cells included in the battery pack 10 are the first to sixth battery cells C1 to C6.

When it is determined that the communication with the CMC 50 is in the normal state, the BMS 60 may derive a cell voltage V1 obtained by dividing a pack voltage V_pack1 of the battery pack 10 derived from the voltage measurement signal received from both ends of the battery pack 10 through the input terminal P3 by the number of battery cells (S201). Here, the pack voltage V_pack1 of the battery pack 10 may be 24 V, and the number of battery cells may be 6. In step S201, each of the cell voltages V1 derived by the BMS 60 for the first to sixth battery cells C1 to C6 is 24/6=4(V).

The BMS 60 may derive cell voltages V_cell of each of the first to sixth battery cells C1 to C6 from the signals indicating the cell voltages of each of the plurality of battery cells received from the CMC 50 (S202). In step S202, the cell voltages V_cell derived by the BMS 60 from the signals indicating the cell voltages received from the CMC 50 for the first to sixth battery cells C1 to C6 are 3.998V, 4V, 3.997V, 4.002V, 4.003V, and 4V in order from the first battery cell C1.

The BMS 60 may derive a cell voltage deviation V_delta by subtracting the corresponding cell voltage among the cell voltages V_cell derived in step S202 from each cell voltage V1 derived in step S201 (S203). In step S203, the cell voltage deviation V_delta of the first battery cell C1, which is obtained by subtracting V_cell from V1 by BMS 60, is 4-3.998 = 0.002 (V). In step S203, the cell voltage deviation V_delta of the second battery cell C2, which is obtained by subtracting V_cell from V1 by BMS 60, is 4-4 = 0 (V). In step S203, the cell voltage deviation V_delta of the third battery cell C3, which is obtained by subtracting V_cell from V1 by BMS 60, is 4-3.997 = 0.003 (V). In step S203, the cell voltage deviation V_delta of the fourth battery cell C4, which is obtained by subtracting V_cell from V1 by BMS 60, is 4-4.002 = -0.002 (V). In step S203, the cell voltage deviation V_delta of the fifth battery cell C5, which is obtained by subtracting V_cell from V1 by BMS 60, is 4-4.003 = -0.003 (V). In step S203, the cell voltage deviation V_delta of the sixth battery cell C6, which is obtained by subtracting V_cell from V1 by BMS 60, is 4-4 = 0 (V).

In step S203, the BMS 60 may store the derived cell voltage deviation V_delta for each of the first to sixth battery cells C1 to C6 in the memory 620.

In step S204, the BMS 60 may determine that the wireless communication with the CMC 50 is in the abnormal state. Referring to FIG. 4, steps S205 and S206 may describe the operation of the BMS 60 when the BMS 60 determines that the wireless communication with the CMC 50 is in the abnormal state.

When it is determined that the communication with the CMC 50 is in the abnormal state, the BMS 60 may derive a cell voltage V2 obtained by dividing a pack voltage V_pack2 of the battery pack 10 derived from the voltage measurement signal received from both ends of the battery pack 10 through the input terminal P3 by the number of battery cells (S205). Here, the pack voltage V_pack2 of the battery pack 10 may be 23.4V, and the number of battery cells may be 6. In step S206, each of the cell voltages V2 derived by the BMS 60 for the first to sixth battery cells C1 to C6 is 23.4/6=3.9 (V).

Since the communication with the CMC 50 is in the abnormal state, the BMS 60 may derive an estimated cell voltage V_cell_EST by subtracting the cell voltage deviation of the corresponding battery cell from the cell voltage deviation V_delta stored in the memory 620 from each of the cell voltages V2 derived in step S205 (S206). In step S206, the estimated cell voltage V_cell_EST obtained by subtracting the cell voltage deviation V_delta from V2 by the BMS 60 for the first battery cell C1 is 3.9-0.002=3.898 (V). In step S206, the estimated cell voltage V_cell_EST obtained by subtracting the cell voltage deviation V_delta from V2 by the BMS 60 for the second battery cell C2 is 3.9-0=3.9 (V). In step S206, the estimated cell voltage V_cell_EST obtained by subtracting the cell voltage deviation V_delta from V2 by the BMS 60 for the third battery cell C3 is 3.9-0.003=3.897 (V). In step S207, the estimated cell voltage V_cell_EST obtained by subtracting the cell voltage deviation V_delta from V2 by the BMS 60 for the fourth battery cell C4 is 3.9- (-0.002)=3.902 (V). In step S207, the estimated cell voltage V_cell_EST obtained by subtracting the cell voltage deviation V_delta from V2 by the BMS 60 for the fifth battery cell C5 is 3.9- (-0.003)=3.903 (V). In step S207, the estimated cell voltage V_cell_EST obtained by subtracting the cell voltage deviation V_delta from V2 by the BMS 60 for the sixth battery cell C6 is 3.9-0=3.9 (V).

In this way, the BMS 60 may determine whether the wireless communication with the CMC 50 is in the normal state, diagnose the battery pack 10 based on the plurality of cell voltages and the plurality of cell temperatures of the plurality of battery cells received from the CMC 50 in the case of the normal state, and estimate the cell voltage based on the pack voltage and the cell voltage deviation 621 stored in the memory 620 in the normal state in the case of the abnormal state, estimate the cell temperature based on the pack current, the coolant temperature, and the lookup table 622 pre-stored in the memory 620, and diagnose the battery pack 10 based on the estimated cell voltage and cell temperature.

Although the embodiments of the present disclosure have been described in detail above, the scope of the present disclosure is not limited thereto, and various modifications and improvements by those of ordinary skill in the field to which the present disclosure pertains belong to the scope of the present disclosure.

## Claims

1. A battery system, comprising:
a battery pack that includes a plurality of battery cells;
a cell monitoring controller (CMC) that is configured to monitor a plurality of first cell voltages and a plurality of first cell temperatures of the plurality of battery cells; and
a battery management system (BMS) that is configured to determine a wireless communication status with the CMC, diagnose the battery pack based on the plurality of first cell voltages and the plurality of first cell temperatures received from the CMC according to the wireless communication status with the CMC, and diagnose the battery pack by estimating a plurality of second cell voltages and a plurality of second cell temperatures of the plurality of battery cells.

2. The battery system of claim 1, wherein:
the BMS includes
a main control unit (MCU) that derives cell voltage deviations of each of the plurality of battery cells based on a pack voltage of the battery pack and stores the derived cell voltage deviations in a memory, when the wireless communication status with the CMC is in a normal state; and
a diagnostic unit that diagnoses the battery pack based on the plurality of first cell voltages and the plurality of first cell temperatures received from the CMC, when the wireless communication status with the CMC is in the normal state.

3. The battery system of claim 2, wherein:
the BMS further includes at least one input terminal that is electrically connected to at least one of two terminals of the battery pack, and
the MCU determines, as the cell voltage deviations of each of the plurality of battery cells, a value obtained by subtracting each of the plurality of first cell voltages from a value obtained by dividing the pack voltage of the battery pack derived based on a pack voltage signal received from at least one of the two terminals of the battery pack by a number of the plurality of battery cells.

4. The battery system of claim 1, wherein:
the BMS further includes a cell voltage estimation unit that determines, as the plurality of second cell voltages, a value obtained by subtracting a cell voltage deviation stored in a normal state before an abnormal state of the wireless communication with the CMC from a value obtained by dividing a pack voltage of the battery pack derived from a pack voltage signal received from at least one of two terminals of the battery pack by a number of the plurality of battery cells, when the wireless communication with the CMC is in the abnormal state.

5. The battery system of claim 1, further comprising:
a cooling unit that includes an inlet into which a coolant is injected and an outlet through which the coolant is discharged to cool the battery pack by heat exchange with the battery pack through the coolant;
a first temperature sensor that measures a temperature of the inlet of the cooling unit;
a second temperature sensor that measures a temperature of the outlet of the cooling unit; and
a current sensor that measures a pack current of the battery pack,
wherein the BMS further includes:
a first input terminal that is electrically connected to the first temperature sensor;
a second input terminal that is electrically connected to the second temperature sensor;
a third input terminal that is electrically connected to the current sensor; and
a communication unit that receives the plurality of first cell voltages and the plurality of first cell temperatures received from the CMC via wireless communication.

6. The battery system of claim 5, wherein:
a memory pre-stores a lookup table that indicates cell temperature values according to ranges of the pack current and coolant temperature, respectively, through a pack test for the battery pack,
the BMS further includes a cell temperature estimation unit that calculates the temperature of the coolant from the temperature of the inlet and the temperature of the outlet and derives a temperature of a plurality of second cells based on the temperature of the coolant, the pack current, and the lookup table, when the wireless communication with the CMC is in an abnormal state, and
the diagnostic unit diagnoses the battery pack based on the plurality of second cell voltages and the plurality of second cell temperatures when the wireless communication with the CMC is in the abnormal state.

7. A battery pack diagnosis method by a battery system that includes a battery pack including a plurality of battery cells, a cell monitoring controller (CMC) configured to monitor a plurality of first cell voltages and a plurality of first cell temperatures of the plurality of battery cells, and a battery management system (BMS) configured to diagnose the battery pack, the method comprising:
determining a wireless communication status with the CMC; and
diagnosing the battery pack based on the plurality of first cell voltages and the plurality of first cell temperatures received from the CMC according to the wireless communication status with the CMC and diagnosing the battery pack by estimating a plurality of second cell voltages and a plurality of second cell temperatures of the plurality of battery cells.

8. The method of claim 7, further comprising:
deriving cell voltage deviations of each of the plurality of battery cells based on a pack voltage of the battery pack and storing the derived cell voltage deviations in a memory, when the wireless communication with the CMC is in a normal state; and
diagnosing the battery pack based on the plurality of first cell voltages and the plurality of first cell temperatures received from the CMC, when the wireless communication with the CMC is in the normal state.

9. The method of claim 8, further comprising:
determining, as the cell voltage deviations of each of the plurality of battery cells, a value obtained by subtracting each of the plurality of first cell voltages from a value obtained by dividing the pack voltage of the battery pack derived based on a pack voltage signal received from at least one of two terminals of the battery pack by a number of the plurality of battery cells,
wherein the BMS further includes at least one input terminal that is electrically connected to at least one of the two terminals of the battery pack.

10. The method of claim 7, further comprising:
when the wireless communication with the CMC is in an abnormal state,
deriving a pack voltage of the battery pack based on a pack voltage signal received from at least one of two terminals of the battery pack; and
determining, as the plurality of second cell voltages, a value obtained by subtracting a cell voltage deviation stored in a normal state before the abnormal state of the wireless communication with the CMC from a value obtained by dividing the pack voltage of the battery pack by a number of the plurality of battery cells.

11. The method of claim 7, further comprising:
receiving a signal indicating a temperature of an inlet by a first input terminal electrically connected to a first temperature sensor measuring the temperature of the inlet of a cooling unit that includes the inlet into which a coolant is injected and an outlet through which the coolant is discharged to cool the battery pack by heat exchange with the battery pack through the coolant;
receiving a signal indicating a temperature of the outlet by a second input terminal electrically connected to a second temperature sensor measuring the temperature of the outlet of the cooling unit;
receiving a signal indicating a pack current by a third input terminal electrically connected to a current sensor measuring the pack current of the battery pack; and
receiving the plurality of first cell voltages and the plurality of first cell temperatures received from the CMC via wireless communication.

12. The method of claim 11, further comprising:
when the wireless communication with the CMC is in an abnormal state,
calculating a temperature of the coolant from the temperature of the inlet and the temperature of the outlet;
deriving the plurality of second cell temperatures based on the temperature of the coolant, the pack current, and a lookup table; and
diagnosing the battery pack based on the plurality of second cell voltages and the plurality of second cell temperatures when the wireless communication with the CMC is in the abnormal state,
wherein a memory pre-stores the lookup table that indicates cell temperature values according to ranges of the pack current and the coolant temperature, respectively, through a pack test for the battery pack.
